Europäisches Patentamt

(19) European Patent Office

Office européen des brevets

(11) Publication number : **0 499 386 A2**

(12) **EUROPEAN PATENT APPLICATION**

(21) Application number : 92300807.2

(22) Date of filing : 30.01.92

(51) Int. Cl.⁵ : **B23Q 3/00, H05K 3/00**

(30) Priority : **11.02.91 GB 9102850**

(43) Date of publication of application :
**19.08.92 Bulletin 92/34**

(84) Designated Contracting States :
**DE GB IT**

(71) Applicant : **DEK PRINTING MACHINES LIMITED**
**11 Albany Road, Granby Industrial Estate**
**Weymouth, Dorset DT4 9TH (GB)**

(72) Inventor : **Willshere, Jeffrey Richard**
**2 Radipole Park Drive**
**Weymouth, Dorset (GB)**
Inventor : **Beale, Stephen James**
**27a Spa Road**
**Weymouth, Dorset DT3 5EP (GB)**

(74) Representative : **Purvis, William Michael Cameron et al**
**D. Young & Co. 10 Staple Inn**
**London WC1V 7RD (GB)**

(54) **Workpiece support and clamping means.**

(57) Support means for a workpiece (3), for example a printed circuit board to be screen printed, comprise a plurality of parallel upright elongate members (19), upper ends of which engage the underside of the workpiece (3) or components secured thereon. Means are provided in a housing (15) selectively to clamp the elongate members (19) in a raised position or allow them to fall to a lowered position, such means comprising collars of shape memory alloy which grip the elongate members but release them when heated or armatures and electro-magneto magnets.

Clamping means to clamp the workpiece (3) comprise clamping plates (32, 33) on opposite sides of the workpiece (3) and having very thin foils (44) projecting laterally therefrom over the workpiece (3) and operating means (34, 35, 36) to lower or raise the clamping plates (32, 33) to clamp or release the workpiece (3).

FIG.5

The invention relates to workpiece support and clamping means.

It is frequently necessary to locate and support a workpiece in a determined position and orientation so that an operation can be effected thereon, particularly an operation which applies pressure to the workpiece, which pressure must be absorbed and resisted by the workpiece support means without causing damage to the workpiece. It may well be necessary to support the workpiece at several locations to prevent it distorting under the force applied to it by the operation.

The invention has particular although not exclusive application to support means for printed circuit boards to form electronic circuits during a printing operation thereon, which circuit boards may already include, on a face thereof opposite to the face which is to be printed, circuit components which project from the face of the board.

Since the board may be of considerable size, for example 500mm square and relatively thin, it cannot be supported merely by its edges on spaced supports of a conveyor, but must be supported, when at a printing position, by support means applied to the underside of the board or to projections on the underside of the board at positions intermediate the edges. Forming a shaped support member to support the board at determined positions and at determined heights at such positions can be a very time consuming operation which is very uneconomic when there is only to be a short print run.

It is also desirable to provide means to secure a board in position against upward movement. Vacuum suction has been proposed but is unsatisfactory particularly when the underside of the board to which vacuum means must be applied is not smooth, for example it may have components thereon, or if the board includes through holes such as those intended to receive wires to connect components.

According to one aspect of the invention there is provided workpiece support means, to support a face of a workpiece during an operation in which a force is applied to another face of the workpiece, comprising a support surface, an array of elongate members each extending through the support surface, a respective end surface on each of the elongate members, clamping means supported on the support surface and provided one on each of the elongate members, and holding means to act upon the clamping means selectively to cause them to hold the respective elongate member in a raised position whereby the elongate members are supported against axial movement with respect to the support surface and said end surfaces of said elongate members in a raised position provide support for the workpiece.

Advantageously the clamping means are annular collars and the holding means comprise means to adjust the temperature of the collars to cause them to grip or not to grip the respective elongate member.

Preferably the collars are provided of shape memory alloy as hereinafter defined.

By shape memory alloy is meant a metal which has the ability to memorise shape and to revert to or recover its previous shape when heated above a temperature at which it was deformed.

In one method of forming a support of the elongate members a gentle biasing force is applied to each of the elongate members pressing it axially towards the workpiece, heating force is applied to the collars to raise their temperature and cause them to expand so as not to grip the elongate members and the workpiece is pressed against those ends of the elongate members which lie on the same side of the support surface as the collars to move axially those elongate members which are located at positions at which there are projections on the workpiece. When all the elongate members are in abutting contact with the workpiece the heating means is cut off and the collars, as they cool, grip the elongate members to prevent the elongate members being pressed further through the support surface and to cause the elongate members to provide with their said ends, a support for the workpiece. If one of the projections on the workpiece is too delicate to have a support applied thereto during the printing operation, such a delicate projection on the workpiece can be covered by a layer of material, for example adhesive tape when setting the support means, which will space the respective elongate member away from the projection of the workpiece.

The heating means could comprise for example a plenum chamber provided by locating a further wall spaced from the support surface, in which plenum chamber the collars would be provided. Alternatively and preferably, the heating means could comprise electrical resistance means through which electrical current could be supplied, such resistance means being provided for example wrapped around a respective collar. Cooling means such as a cold air draught could be provided to speed up constriction of the collars onto the elongate members after the heating means was deenergised.

The gentle biasing means provided to move the elongate members towards the workpiece may comprise elevated air pressure in a compartment into which the opposite ends of the elongate members to said ends extend, so that the elevated air pressure is applied to the opposite ends of the elongate members.

By providing means to provide a bias force both towards the workpiece and away from the workpiece for the elongate members and by having programmable heating means for the individual collars, a workpiece support could be set up without the use of a workpiece or dummy workpiece by, for example, retracting all the elongate members to a position remote from the workpiece, selectively heating the respective collars of particular elongate members and applying a force to bias the elongate members towards the workpiece whereby only those elongate members whose collars had been heated would be free to advance towards the workpiece, the other elongate members remaining in a retracted position.

The invention is not limited to planar workpieces, but could be applied to holders for workpieces of other shape.

The elongate members could for example be 200 in number provided in a regular grid formation to provide a support area variable in size but having a maximum size approximately 500mm square.

In an alternative construction the clamping means comprise electro-magnets to act upon the elongate members and the holding means comprise means selectively to supply electric current to the electro-magnets.

Advantageously each of the elongate members has an armature plate at the end thereof remote from said one end, the electromagnets comprise annular collars secured to the support surface and the elongate members extend through the annular collars.

Biasing means may be provided to raise the armature plates of the elongate members into close proximity with the annular collars and may comprise a lifting plate provided beneath the armatures of a plurality of the elongate members and means to raise the lifting plate.

According to another aspect of the invention there is provided workpiece clamping means to clamp a workpiece on a conveyor while a screen printing operation is effected on a face of the workpiece, the clamping means comprising a pair of plates located at opposite sides of the workpiece, thin foils projecting laterally from the plates to overlie edge portions of said face of the workpiece and operating means to raise and lower the pair of plates selectively to cause the thin foils to apply a clamping force to the workpiece.

Thus a screen through which printing is effected can overlie the plates during the printing operation without the screen being damaged by a squeegee pressing it against the plates and the workpiece.

Preferably the thin foils have angled end portions and are secured by adhesive to the pair of plates which are raised and lowered by the operating means.

Advantageously the operating means comprise downwardly acting air pistons to effect clamping and spring return means.

The invention is diagrammatically illustrated by way of example in the accompanying drawings in which:-

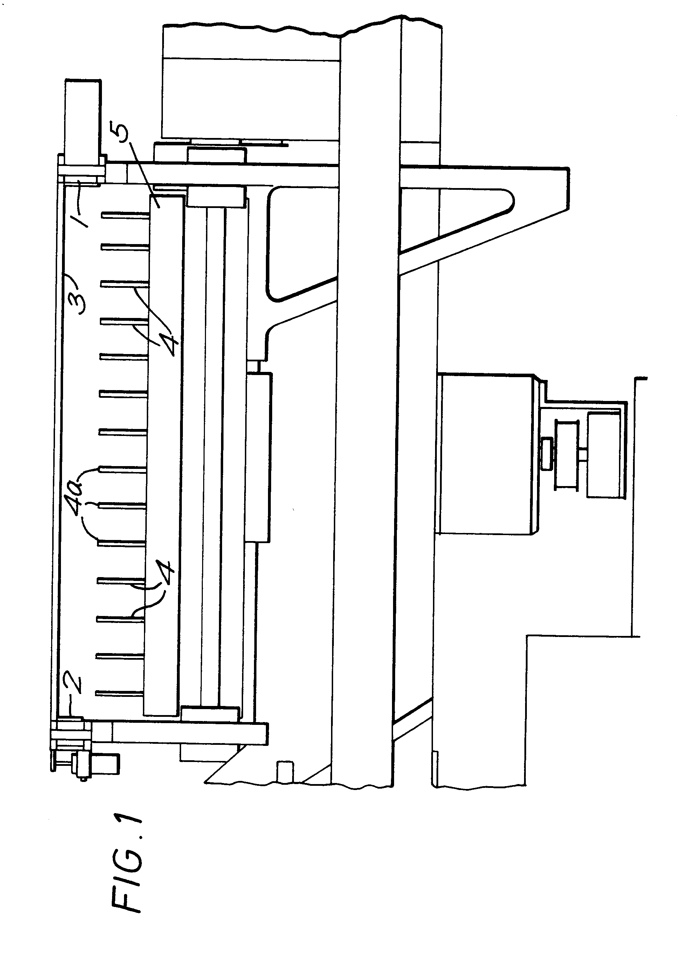

Figure 1 is an elevation through part of a screen printing machine showing one embodiment of workpiece support means according to the invention for printed circuit boards to be printed by the machine;

Figure 2 is a sectional view corresponds to Figure 1;

Figure 3 is a partly sectioned elevation through another embodiment of workpiece support means according to the invention;

Figure 4 is plan view corresponding to Figure 3;

Figure 5 is a partly sectioned perspective view of workpiece clamping means according to the invention;

Figure 6 is a view taken on arrow VI of Figure 5;

Figure 7 is a greatly enlarged view of the portion indicated by the circle VII of Figure 6;

Figure 8 is a partly sectioned view taken in the direction of arrow VIII of Figure 5;

Figure 9 shows a plan view of a clamping plate of the clamping means of Figures 5 to 8; and

Figure 10 is an end view corresponding to Figure 9.

Referring to the drawings, a screen printing machine includes spaced conveyor members 1 and 2 on which a printed circuit board 3 to be printed can be supported by its edges. It is necessary however to support the printed circuit board at positions intermediate the members 1 and 2 while the upper surface is printed since otherwise it would bow downwardly. The means to support the printed circuit board 3 comprises support means in the form of an array of elongate members 4 each projecting vertically from a housing 5. The housing 5 is raisable to cause the upper ends 4a of the elongate members 4 to abut the underside of the circuit board 3 to support it during a printing operation. Preferably the members 4 actually raise the circuit board 3 above the position shown together with the conveyor members 1 and 2 into a printing position at which a printing head acts on the circuit board 3 for example with a downward force of 20 Kg.

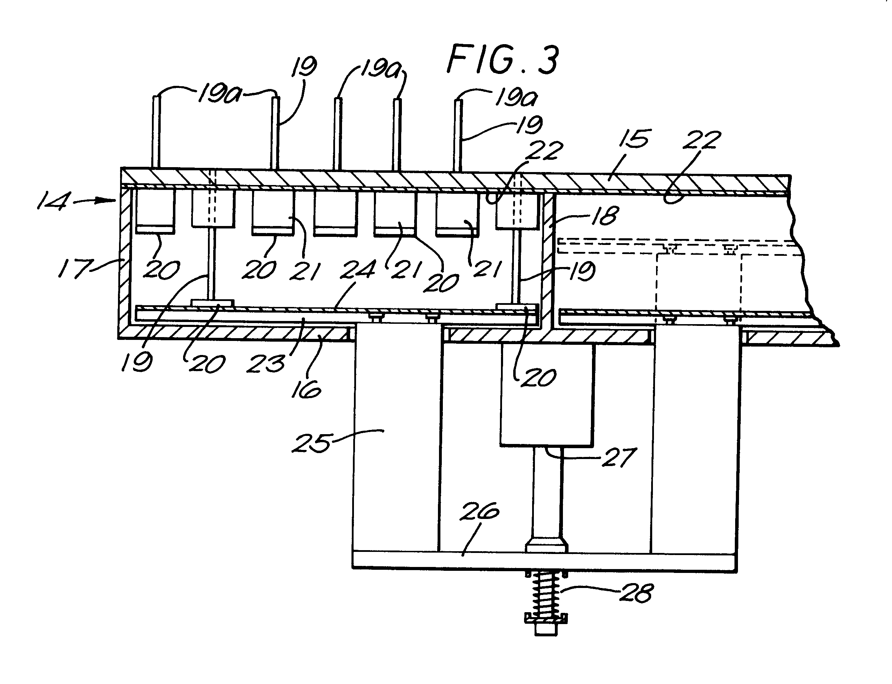

The circuit board 3 may already have circuit components on its underside which physically project downwardly from the underside and which therefore prevent the circuit board being supported merely by a planar support member. Thus to compensate for the irregular profile of the underside of the circuit board 3 it is necessary, if the circuit board 3 is to be adequately and evenly supported, for the upper ends 4a of the elongate members 4 to be at different heights. Referring to Figure 3 it can be seen that the support 5 actually comprises three-spaced members comprising a lower cover 6, a support member 7 and an upper cover 8. The elongate members 4 extend through aligned bores 9 and 10 in the upper cover 8 and the support member 7 respectively and also each project through a respective annular collar 11 which is supported on the upper side of the support 7. Each collar 11 is formed of a shape memory alloy which below a determined temperature, for example 70°C, firmly grips the respective elongate member 4 passing therethrough but above such determined temperature allows the respective elongate member to move freely therethrough.

Each collar 11 has an electrical resistance 12 wound therearound which, when supplied with electrical current, produces a heating effect to raise the temperature of the collar above the determined temperature. Means 13 are provided to pass air, as indicated by arrow 13a, between the upper cover 8 and the support 7 to cool the collars 11 after heating has stopped by discontinuing the passage of current through the resistances 12.

Means 14 are provided to apply either pressure or vacuum in the space between the lower cover 6 and the support 7, as indicated by the double headed arrow 14a, thereby to act upon lower ends 4b of the elongate members 4 by providing an upward biasing force on the elongate members 4 to raise them through the collars 11 or a suction force to draw the elongate members 4 down through the collars 11.

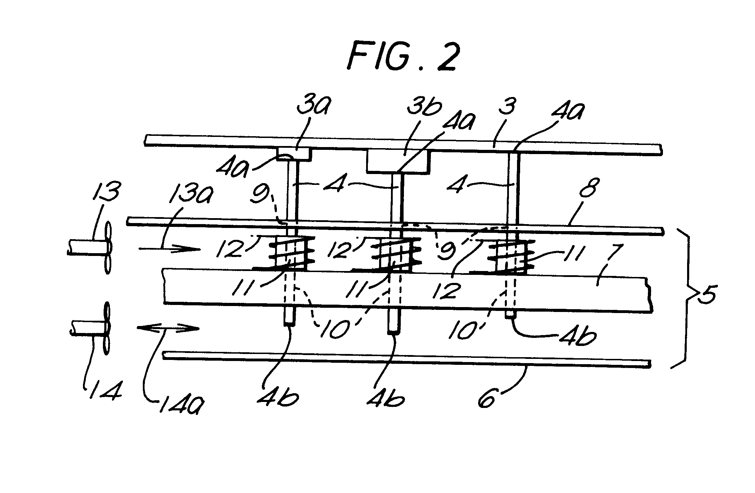

In one method of operation as shown in Figure 2 the resistances 12 are all energized to heat the collars, the space between the lower cover 6 and the support 7 is subjected to vacuum to draw the collars downwardly, a board 3 with circuit component 3a and 3b on the underside thereof is arranged over the elongate members 4 and the space between the lower cover 6 and the support 7 is pressurised with air to raise the upper ends 4a of all the elongate members 4 into abutment with the undersides of the circuit components 3a and 3b and the circuit board 3. With the air pressure maintained, the electrical current to the resistors 12 is cut-off and cooling air is passed between the upper cover 8 and the support 7 to shrink the collars 11 to cause them to grip the elongate members 4 and to form the upper ends 4a of the elongate members 4 into a workpiece support means which provides even support for the circuit board 3.

In another method of forming a workpiece support means, stops (not shown) can be provided on the elongate members 4 to limit their upward and downward travel, the resistances 12 can be selectively energized and pressure or vacuum can be applied as required to the space between the lower cover 6 and the support 7 to move only those of the elongate members 4 whose collars 11 have been expanded either upwardly or downwardly as required to form a support means of desired profile.

The shape memory alloy of the collars 11 may for example be a beryllium alloy and be manufactured by Memory Metals Limited of 3, Penny Corner, Farthing Road, Ipswich IP1 5AP or by Thomas Bolton and Johnson Ltd of PO Box 1, Froghall, Stoke-on-Trent ST10 2HF.

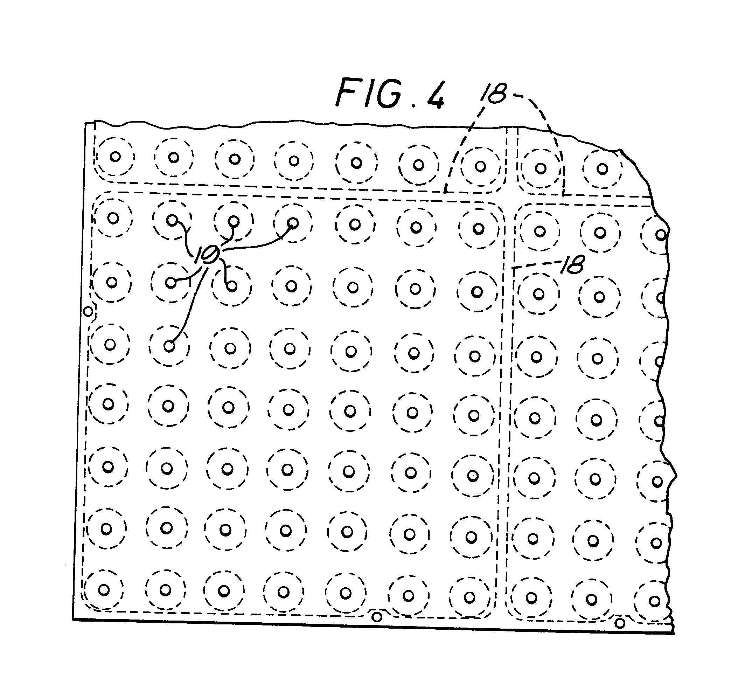

In the embodiment shown in Figures 3 and 4, a support surface 15 is provided as a perforated plate forming the lid of a housing 14 having a lower wall 16 a peripheral wall 17 and intermediate walls 18, the intermediate walls 18 dividing the housing into four compartments. In each of two of the compartments forty-nine elongate members 19 are provided in a seven by seven array and in each of the other two of the compartments fifty-six elongate members are provided in a seven by eight array. Each elongate member 19 has at the lower end thereof an armature plate 20 of magnetic material. For each elongate member 19a a respective electro-magnet 21 of annular form is provided secured beneath the perforated support plate 15 with the central bore in the annular magnet 21 aligned with the respective perforation in the support plate 15. A printed circuit board 22 is secured on the underside of the perforated plate 15 and the electro-magnets 21 are mounted on the printed circuit board 22 and are electrically connected thereto so that by means of the printed circuit board they can be supplied with energising current.

In the bottom of each of the four compartments a respective lifting plate 23 is provided with a weakly-magnetic mat 24 on its upper face. Each lifting plate 23 is connected by a respective lifting column 25 to a main lifting plate 26 which is raisable and lowerable by means of a piston cylinder arrangement 27 with an over stroke compensator in the form of spring means 28. Bearing means (not shown) are provided for the columns 25 to restrain them for vertical movement only. Thus by means of the piston cylinder arrangement 27, the lifting plates 23 can be moved between the lowered position shown in full lines in Figure 3 and the raised position shown in dotted lines at the right hand side of Figure 3. In the raised position of the lifting plates 23 the armature plates 20 of all forty-nine or fifty-six of the elongate members 19 located thereabove are raised so that the armature plates 20 are in abutment with the undersides of the respective electro-magnets 21 through which they project. If the electro-magnets 21 are then selectively energised by way of the printed circuit boards 22, the armature plates 20 of the energised magnets will be attracted to the magnets 21 and will support the respective elongate members 19 in a raised position. Upon lowering of the lifting plates 23 by expanding the piston cylinder arrangement 27, those of the elongate members 19 corresponding to magnets 21 which are not energised will move downwardly with the lifting plate 23 (as shown at the right hand side of the left hand compartment in Figure 3 and one in from the left hand side of the left hand compartment in Figure 3) but all those of the elongate members 19 corresponding to energised magnets 21 will be retained in a raised position and the upper end surfaces 19a of those raised elongate members 19 will form a support for a workpiece. Thin annular washers (not shown) of non-magnetic material are advantageously provided on the upper surfaces of the armature plates 20 to form an air gap to prevent residual magnetism from retaining the armature plates 20 on the undersides on unenergised magnets 21.

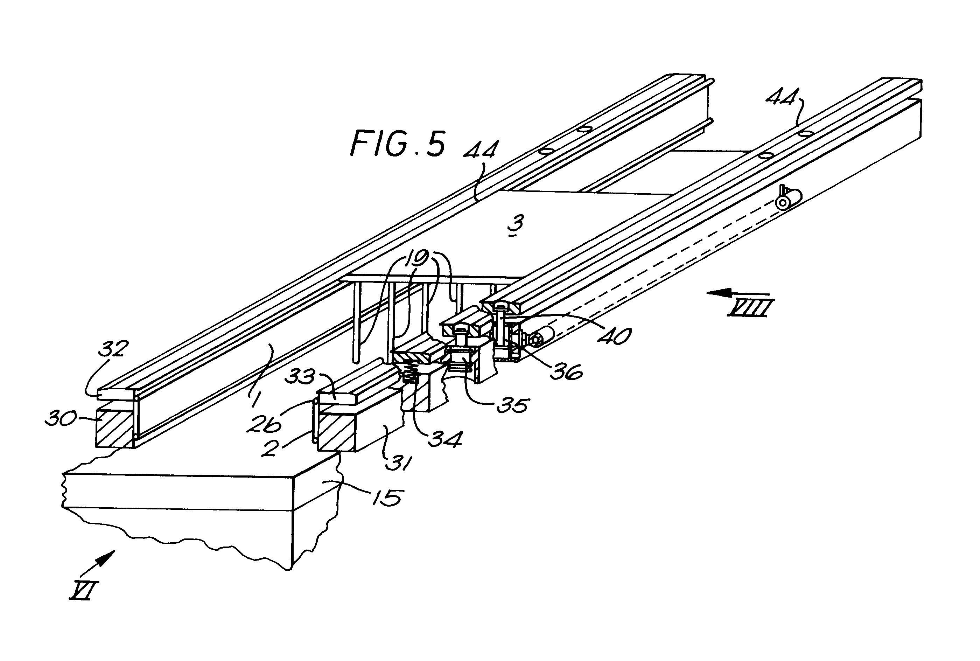

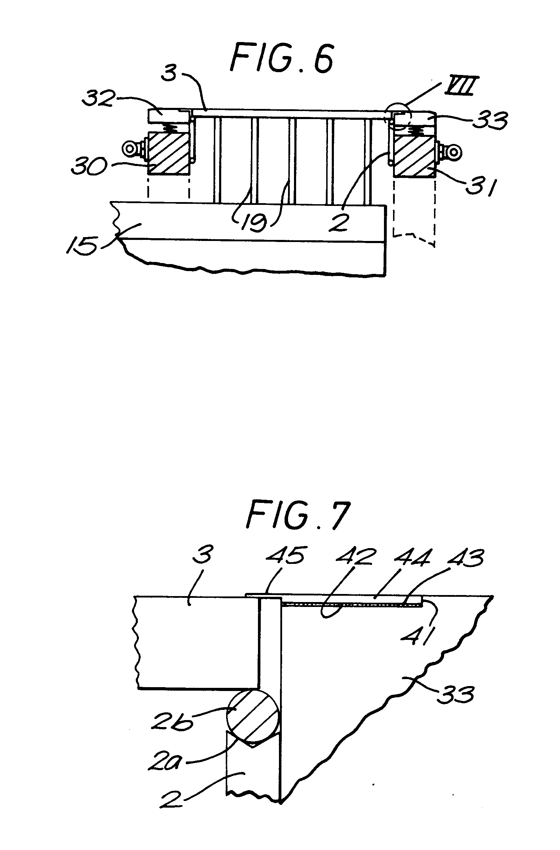

Referring to Figures 5 to 10, workpiece clamping means are provided to clamp a printed circuit board 3 during screen printing of the upper face thereof. The printed circuit board 3 is provided on the spaced conveyor members 1 and 2 and, as can be seen in Figure 7, the spaced conveyor member 2 comprises a fixed strip with a V-shaped groove 2a in its upper surface in which a conveyor band 2b moves longitudinally to convey the printed circuit board to a printing position and, after printing, from the printing position. Figures 5, 6 and 8 show that the printed circuit board 3 when at the printing position is supported by the upper ends of a plurality of elongate members, for example the elongate members 19 of Figures 3 and 4, projecting from a support 15.

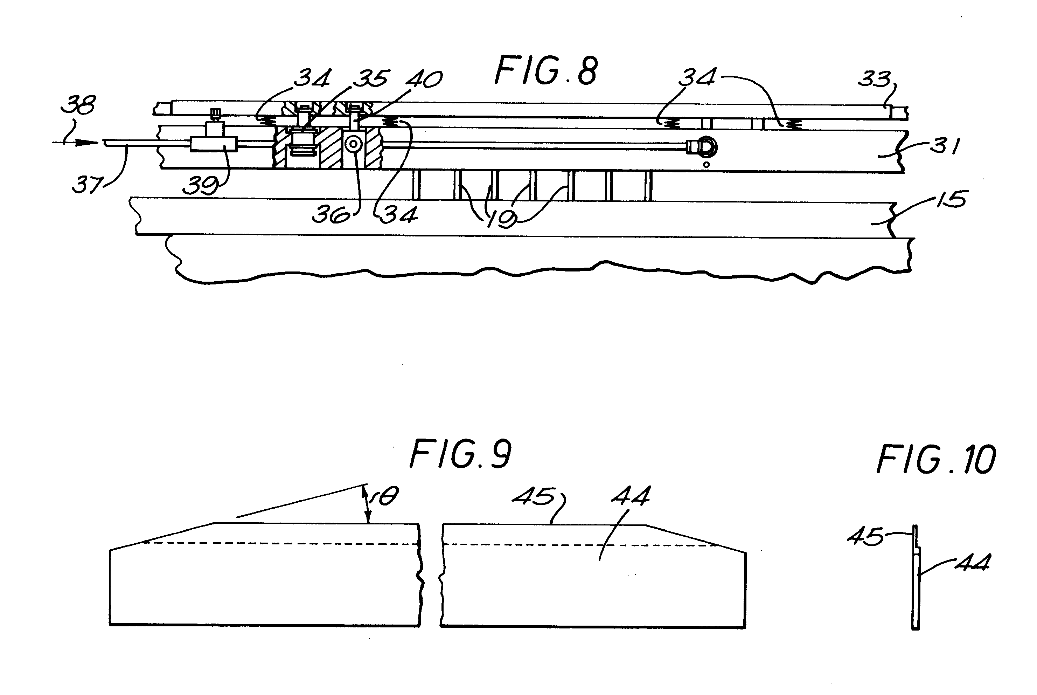

The spaced conveyor members 1 and 2 are mounted on support strips 30 and 31 and respective upper strips 32 and 33 are mounted above the strips 30 and 31. At each end of each of the upper strips 32, 33, connecting means are provided to the respective underlying support strip 30, 31. Referring to Figure 5 and considering the strips 31 and 33 it can be seen at the near end that the strips 31, 33 are coupled together by a compression coil spring 34, a linear bearing 35 and a piston and cylinder arrangement 36. The compression spring 34 biasses the upper strip 33 upwardly away from the support strip 31, the linear bearing 35 restrains upward and downward movement of the strip 33 with respect to the strip 31 to vertical movement and the piston cylinder arrangement 36 is supplied with compressed air through a pipe 37 as indicated by arrow 38 in Figure 8 via a flow regulator 39. The piston cylinder arrangement 36 comprises a piston rod 40 secured at its upper end to the upper strip 33 and having a piston at its lower end engaged in a cylinder in the support strip 31, a port in the cylinder wall through which compressed air is supplied being provided above the piston thereby providing a single acting piston which can apply a downward force to move the upper strip 33 towards the strip 31 in opposition to the force of the compression coil springs 34.

As can be seen in Figure 7, the upper face of the upper strip 33 is rebated at its inner edge to form a recess with a vertical face 41 and a horizontal face 42. Secured within the recess by adhesive 43 is a clamping plate 44 which is cantilevered out from the upper strip 33 and has a recess in its underside at its inner edge so to form an integral foil 45. Thus the foil 45 is provided at the edge of the upper strip 33 which is closest to the opposing upper strip 32 which has a respective clamping plate 44 with clamping foil 45 thereon. The clamping foils 45 overlie the edges of the printed circuit board 3 and apply a downward force thereto.

The clamping plate 44 with the clamping foil 45 is shown in Figures 9 and 10 and it can be seen that inner corners are cut away at an angle ∅ of for example 15 degrees. The plate 44 may for example be 500mm in length, 0.5mm in thickness and have an overall width of 10mm, the foil 45 representing 2mm of that width and the foil 45 having a thickness of 0.1mm. The angled corner portions extend for 10mm of the length of the strip at each end.

It will be seen therefore that the step provided between the upper face of the clamping plate 44 and the upper face of the printed circuit board 3 being printed is only 0.1mm high and thus the printing screen will not be damaged by extending over the step and having the squeegee passed thereover under pressure. The printed circuit board can however be reliably retained in position during the printing operation.

## Claims

1. Workpiece support means, to support a face of a workpiece (3) during an operation in which a force is applied to another face of the workpiece (3), comprising a support surface (5, 15), an array of elongate members (4, 19) each extending through the support surface (5,15), a respective end surface (4a, 19a) on each of the elongate members (4, 19), clamping means (11, 20, 21) supported on the support surface (5, 15) and provided one on each of the elongate members (4, 19), and holding means (11, 13A, 22) to act upon the clamping means selectively to cause them to hold the respective elongate member (4, 19) in a raised position whereby the elongate members (4, 19) are supported against axial movement with respect to the support surface (5, 15) and said end surfaces (4a, 19a) of said elongate members in a raised position provide support for the workpiece (3).

2. Workpiece support means according to claim 1, in which the clamping means are annular collars (11) and the holding means comprise means (12, 13a) to adjust the temperature of the collars (11) to cause them to grip or not to grip the respective elongate member (4).

3. Workpiece support means according to claim 2, in which the collars (11) are formed of shape memory alloy.

4. Workpiece support means according to claim 2 or claim 3, in which the holding means comprises electrical resistance means (12) to which electrical current can be supplied to heat selected ones of the collars (11).

5. Workpiece support means according to claim 2 or claim 3, in which the holding means comprises a plenum chamber formed by the support surface (7) and another wall (8) spaced therefrom with the plenum chamber containing the collars (11) and means (13) to heat or cool the atmosphere in the plenum chamber.

6. Workpiece support means according to any of the preceding claims, including biasing means (14) to bias the elongate members towards a raised position.

7. Workpiece support means according to claim 6, in which the biasing means (14) comprises elevated air pressure, in a compartment into which the opposite ends (4b) of the elongate members to said ends (4a) entered, to act on the opposite ends (4b) of the elongate members (4) to said one ends (4a).

8. Workpiece support means according to claim 1, in which the clamping means comprise electro-magnets (21) to act upon the elongate members (19) and the holding means (22) comprise means selectively to supply electric current to the electro-magnets (21).

9. Workpiece support means according to claim 8, in which each of the elongate members (19) has an armature plate (20) at the end thereof remote from said one end (19a), the electro-magnets (21) comprise annular collars secured to the support surface (15) and the elongate members (19) extend through the annular collars.

10. Workpiece support means according to claim 9, including biasing means (23) to raise the armature plates (20) of the elongate members (19) into close proximity with the annular collars.

11. Workpiece support means according to claim 10, in which the biasing means comprise a lifting plate (23) provided beneath the armatures (20) of a plurality of the elongate members (19) and means (27) to raise the lifting plate (23).

12. Workpiece clamping means to clamp a workpiece (31) on a conveyor (12) while a screen printing operation is effected on a face of the workpiece (3), the clamping means comprising a pair of plates (32, 33) located at opposite sides of the workpiece (3), thin foils (45) projecting laterally from the plates (32, 33) to overlie edge portions of said face of the workpiece (3) and operating means (34, 35, 36) to raise and lower the pair of plates (32, 33) selectively to cause the thin foils (45) to apply a clamping force to the workpiece (3).

13. Workpiece clamping means according to claim 12, in which the thin foils (45) have angled end portions and are secured by adhesive (43) to the portion of plates (32, 3) which are raised and lowered by the operating means (34, 35, 36).

14. Workpiece clamping means according to claim 13, in which the operating means comprise downwardly acting air pistons (36) to effect clamping and spring return means (34).

FIG.1

FIG. 2

FIG. 3

# FIG.4

FIG.5

EP 0 499 386 A2

# FIG.6

# FIG.7

FIG.8

FIG.9

FIG.10